(19) **Europäisches Patentamt**
**European Patent Office**
**Office européen des brevets**

(11) **EP 2 409 285 B1**

(12) **FASCICULE DE BREVET EUROPEEN**

(45) Date de publication et mention
de la délivrance du brevet:
**03.07.2013 Bulletin 2013/27**

(21) Numéro de dépôt: **10709721.4**

(22) Date de dépôt: **15.03.2010**

(51) Int Cl.:
*G08C 19/00* (2006.01)       *H04B 7/005* (2006.01)
*H04B 7/185* (2006.01)

(86) Numéro de dépôt international:
**PCT/EP2010/053294**

(87) Numéro de publication internationale:
**WO 2010/106019 (23.09.2010 Gazette 2010/38)**

(54) **DISPOSITIF DE PILOTAGE EN FREQUENCE POUR EMMETTEUR/RECEPTEUR DE TELECOMMANDE SATELLITE, EMETTEUR ET RECEPTEUR ASSOCIES**

EINRICHTUNG ZUM STEUERN DER FREQUENZ EINES FERNGESTEUERTEN SATELLITENSENDERS-/EMPFÄNGERS UND DIESBEZÜGLICHER SENDER UND EMPFÄNGER

DEVICE FOR CONTROLLING THE FREQUENCY OF A SATELLITE REMOTE-CONTROLLED TRANSMITTER/RECEIVER, AND RELATED TRANSMITTER AND RECEIVER

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **17.03.2009 FR 0901235**

(43) Date de publication de la demande:
**25.01.2012 Bulletin 2012/04**

(73) Titulaire: **THALES**
**92200 Neuilly-sur-Seine (FR)**

(72) Inventeurs:
• **NASTA, Rodolphe**
**F-31100 Toulouse (FR)**

• **POPULUS, Thierry**
**F-31470 Fontenilles (FR)**

(74) Mandataire: **Lucas, Laurent Jacques**
**Marks & Clerk France**
**Conseils en Propriété Industrielle**
**Immeuble Visium**
**22, Avenue Aristide Briand**
**94117 Arcueil Cedex (FR)**

(56) Documents cités:
**WO-A1-96/08883       US-B1- 6 282 184**
**US-B1- 6 484 014**

Printed by Jouve, 75001 PARIS (FR)

**Description**

La présente invention se rapporte à un dispositif de pilotage en fréquence pour un récepteur de télécommande satellite ou un émetteur de télémesure satellite.

L'ensemble émetteur/récepteur est situé à bord d'un satellite géostationnaire ou défilant et met en oeuvre une liaison de télémesure, télécommande et mesure de distance entre les stations au sol et ledit satellite. Cette liaison est connue sous l'appellation liaison TTC, acronyme de l'anglais Telemetry, Tracking and Command, en français télémesure, poursuite et télécommande, ou sous l'appellation liaison TCR, pour l'anglais Telemetry, Command and Ranging, en français télémesure, télécommande et mesure de distance. Cette liaison est utilisée notamment pour la télécommande du satellite depuis la Terre mais également pour la télémesure, c'est-à-dire pour la transmission depuis le satellite d'informations sur l'état de l'engin. Plus précisément, la liaison de télécommande satellite correspond à la liaison montante entre un émetteur au sol, et un récepteur à bord du satellite. La liaison de télémesure correspond à la liaison descendante entre un émetteur de télémesure situé à bord du satellite et un récepteur situé dans une station au sol.

Dans la suite de la description l'acronyme TTC est utilisé comme référence à la liaison du même nom. Un émetteur TTC désigne un émetteur de télémesure et un récepteur TTC désigne un récepteur de télécommande, les deux équipements étant situés à bord d'un satellite.

Les solutions connues d'architectures d'émetteurs/récepteurs TTC utilisent un oscillateur local délivrant le plus souvent une fréquence fixe ou un nombre restreint de fréquences. Cette fréquence peut néanmoins être rendue programmable par l'utilisation d'un synthétiseur fractionnaire. La plage de variation de la fréquence est généralement très importante et sa programmation se fait à partir d'un incrément de fréquence constant ce qui entraine au final un nombre de fréquences potentielles élevé, ce nombre étant égal à la longueur de la plage dans laquelle la fréquence peut varier divisé par l'incrément de fréquence utilisé.. Cette possibilité de reconfigurer la fréquence initialement fixée permet par exemple de coordonner les fréquences de plusieurs satellites lors d'un changement de position orbitale ou d'éviter certaines fréquences brouillées. Un des inconvénients majeur des architectures TTC à synthétiseur fractionnaire classique est le nombre de fréquences programmables très important que doit prendre en compte le synthétiseur. A titre d'exemple, pour une bande de fréquence de type Ku, un synthétiseur fractionnaire peut mettre en oeuvre 500 000 fréquences différentes pour couvrir une bande totale de 750 MHz. Cette capacité du synthétiseur à pouvoir générer un grand nombre de fréquences différentes présente plusieurs inconvénients.

Tout d'abord le nombre important de fréquences disponibles engendre une impossibilité de valider de façon exhaustive le fonctionnement du pilotage de toutes ces fréquences pour l'émetteur ou le récepteur TTC. De plus, parmi l'ensemble des fréquences disponibles, certaines sont non utilisables car elles correspondent à des bandes de fréquence allouées à un autre canal de télécommunication, ce qui a pour effet d'engendrer des problèmes de fausse alarme. En effet toute fausse commande de pilotage de la fréquence peut aboutir à une configuration critique où le récepteur TTC fonctionne à une fréquence interdite car cette dernière est, par exemple, superposée à une fréquence dédiée à une autre liaison de communication.

Le document WO 96/08883 décrit un appareil de synthèse de fréquences

L'utilisation d'un synthétiseur de fréquence programmable intelligent dont la fonction est de piloter en fréquence un récepteur ou un émetteur TTC permet de pallier aux problèmes mentionnés précédemment. En particulier, la solution retenue par l'invention consiste à mettre en oeuvre conjointement au synthétiseur de fréquence programmable, un dispositif de pilotage en fréquence intelligent dont les pas de fréquence ne sont pas systématiquement réguliers mais permettent de répondre à des exigences précises et spécifiées par l'utilisateur concernant l'utilisation de la bande de fréquence allouée à la liaison TTC. A cet effet, la présente invention a notamment pour objet un dispositif de pilotage de la fréquence d'un émetteur ou d'un récepteur TTC implémentant une commande de fréquence intelligente dont la fonction est de piloter un oscillateur local pour que celui-ci génère une valeur prise dans une plage de fréquence spécifiée et non plus sur la totalité de la bande de fréquence attribuée aux services de radiodiffusion par satellite.

A cet effet, l'invention a pour objet un dispositif de pilotage de la fréquence F d'un émetteur et/ou d'un récepteur de liaison satellite TTC à partir d'une commande de fréquence dont la valeur est prise dans un plan de fréquences prédéterminé composé de plusieurs créneaux de fréquences répartis de façon discontinue dans une bande de fréquence donnée, ledit dispositif étant caractérisé en ce qu'il comprend au moins un oscillateur à quartz délivrant une fréquence de référence $F_{OCXO}$, un oscillateur local synthétisé délivrant ladite fréquence F à partir de ladite fréquence de référence Focxo selon la relation suivante $F = F_{OCXO} \dfrac{N}{R}$ où N et R sont des coefficients diviseurs programmables et un circuit intégré numérique qui implémente une table de conversion faisant correspondre à chaque créneau de fréquence (503,504,505) dudit plan de fréquences prédéterminé un ensemble d'adresses binaires réparties de façon contigüe adressant les valeurs desdits coefficients N et R sous forme de mots binaires permettant à l'oscillateur local synthétisé (101) de générer ladite fréquence F dont la valeur est égale à celle de ladite commande en fréquence.

Dans une variante de réalisation, ledit circuit intégré numérique est un composant à logique programmable ou une mémoire morte.

L'invention a également pour objet un récepteur de télécommande pour un satellite géostationnaire comprenant au moins un circuit d'entrée analogique d'amplification et de filtrage, une première chaine de conversion de fréquence délivrant à sa sortie un signal à une première fréquence intermédiaire et un circuit de démodulation numérique caractérisé en ce que ladite première chaine de conversion de fréquence comprend au moins un mélangeur, un circuit d'amplification et de filtrage et un dispositif de pilotage de la fréquence tel que décrit précédemment.

Dans une variante de réalisation, ledit récepteur comprend en plus une seconde chaine de conversion de fréquence recevant en entrée le signal de sortie de ladite première chaine de conversion de fréquence et délivrant audit circuit de démodulation un signal à une seconde fréquence intermédiaire.

L'invention a également pour objet un émetteur de télémesure pour un satellite géostationnaire ou défilant comprenant au moins un circuit de modulation, un circuit d'amplification et de filtrage et un dispositif de pilotage de la fréquence dudit émetteur tel que décrit précédemment.

D'autres caractéristiques et avantages de la présente invention apparaîtront mieux à la lecture de la description qui suit en relation aux dessins annexés qui représentent :

La figure 1, un synoptique d'un récepteur de télécommande satellite piloté en fréquence par un dispositif selon l'invention,

La figure 2, un synoptique d'un émetteur de télémesure satellite piloté en fréquence par un dispositif selon l'invention,

La figure 3, un schéma d'un exemple de plan des fréquences de pilotage permettant d'éviter des canaux de communication occupés,

La figure 4, un synoptique du dispositif de pilotage en fréquence selon l'invention,

La figure 5, un schéma illustrant le principe de conversion de créneaux de fréquences en adresses binaires.

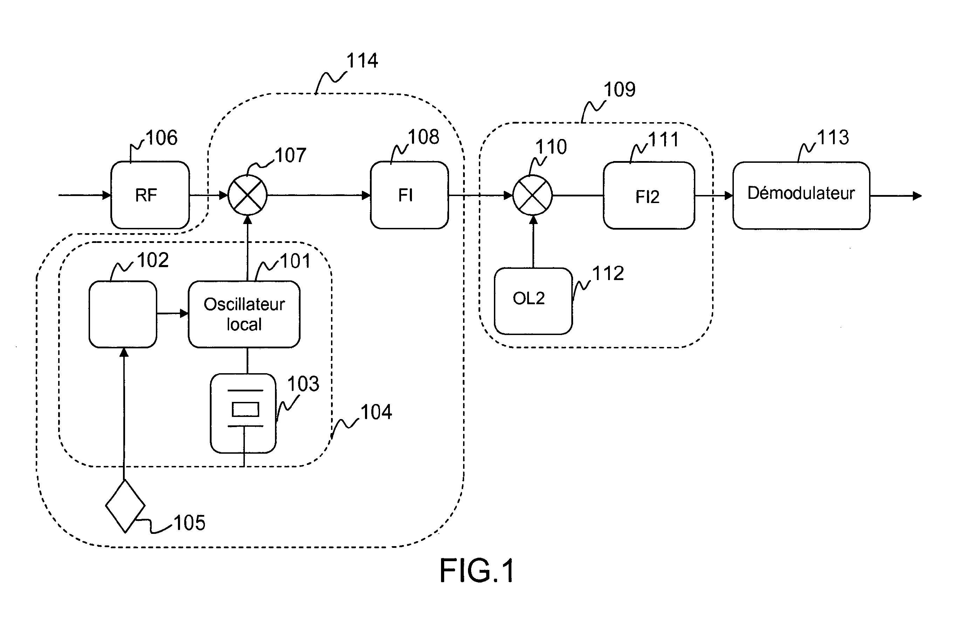

La figure 1 représente un bloc-diagramme d'un récepteur de liaison satellite TTC selon l'invention.

Ce récepteur est composé essentiellement des éléments suivants :

➢ un ensemble de circuits d'entrée analogiques 106 dont la fonction est principalement l'amplification et le filtrage du signal d'entrée et secondairement l'adaptation en impédance dudit signal,
➢ un mélangeur de fréquence 107 associé à un dispositif de pilotage en fréquence 104 selon l'invention et à un ensemble de circuits d'amplification et de filtrage 108. Ces trois éléments constituent une première chaine de passage en fréquence intermédiaire dont la fonction est de convertir la fréquence du signal d'entrée vers la fréquence intermédiaire délivrée par le dispositif de pilotage 104,
➢ une seconde chaine de passage en fréquence intermédiaire 109, qui peut être optionnelle, constituée d'un mélangeur de fréquences 110, d'un oscillateur local 112 délivrant une fréquence fixe et d'un circuit d'amplification 111,
➢ un circuit numérique de démodulation 113 dont la fonction est de démoduler le signal reçu afin de récupérer les données émises.

Le dispositif 104 de pilotage en fréquence comprend principalement un circuit de conversion 102 qui reçoit en entrée une commande en fréquence 105 et qui est apte à piloter numériquement un oscillateur local synthétisé 101 dont la fonction est de délivrer la fréquence dudit récepteur de télécommande satellite qui est ensuite délivrée en entrée du mélangeur 107. L'oscillateur local synthétisé 101 est également relié à un oscillateur à quartz 103 dont la fonction est de délivrer une fréquence de référence à partir de laquelle l'oscillateur local synthétisé 101 génère la fréquence du récepteur de télécommande satellite.

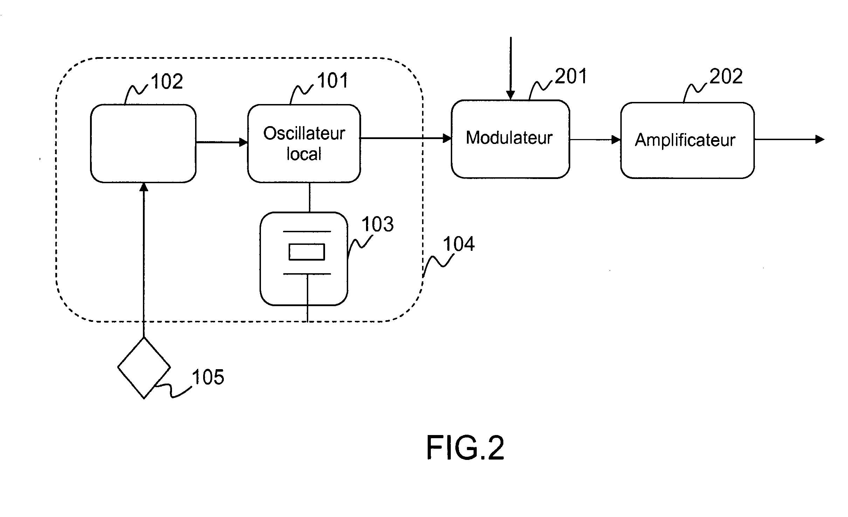

La figure 2 représente un bloc diagramme de l'architecture d'un émetteur de liaison satellite TTC ou émetteur de télémesure selon l'invention. Cette architecture est composée essentiellement des éléments suivants :

➢ un dispositif 104 de pilotage en fréquence tel que décrit précédemment dont la fonction est de générer la fréquence de l'émetteur de télémesure. Ce dispositif 104 est principalement composé d'un circuit de conversion 102 réagissant à une commande de fréquence 105, d'un oscillateur local synthétisé 101 et d'un oscillateur à quartz 103,
➢ un circuit de modulation 201 dont la fonction est de moduler le signal d'entrée à la fréquence générée par le dispositif de pilotage 104,
➢ un ou plusieurs circuits d'amplification et de filtrage 202 qui génèrent à partir du signal modulé, un signal analogique à transmettre.

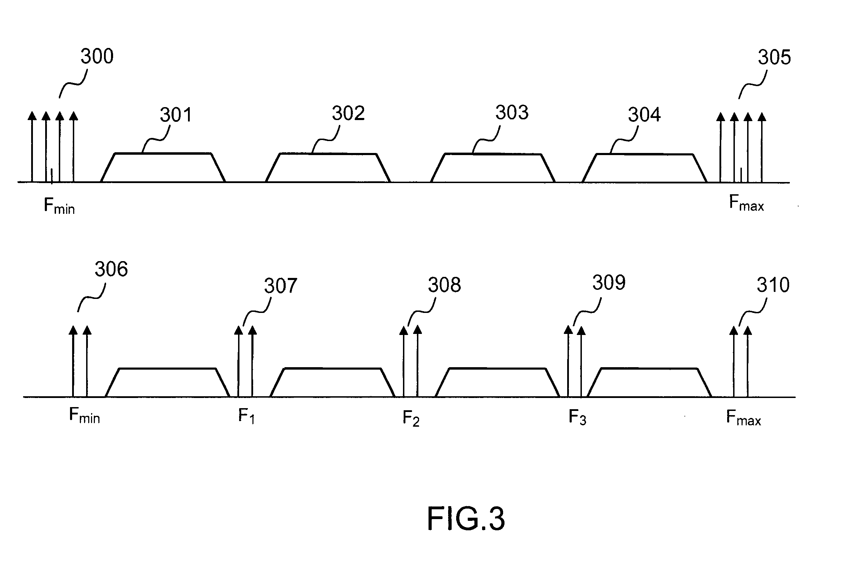

La figure 3 schématise un exemple de plan de répartition des fréquences de commande selon l'invention. Une bande de communication, par exemple une bande de type Ku utilisée par les systèmes de communication par satellite comprend des canaux de télécommunication 301, 302, 303, 304 occupés par d'autres transmissions que celle relative à la liaison satellite TTC. L'invention consiste à limiter le champ des fréquences possibles pour le récepteur de télécommande à certaines fréquences non utilisées dans la bande de communication et spécifiées par les besoins du système. Par exemple, les créneaux de fréquence 300,305 situés autour des fréquences minimum $F_{min}$ et maximum $F_{max}$ de la bande de communication ou les créneaux de fréquence 306,307,308,309,310 situés entre les canaux de télécommunication occupés peuvent être retenus dans le plan des fréquences pour lesquelles le récepteur selon l'invention doit être capable de fonctionner. De façon générale, on peut définir N créneaux de fréquence Si, $1 \leq i \leq N$ à l'intérieur de la bande de communication considérée qui peut être, par exemple, une bande de type Ku, K ou C.. Chacun desdits créneaux Si peut contenir un nombre variable de fréquences $M_i$ réparties de façon régulière ou pas. Le nombre total M de fréquences programmables auxquelles le récepteur de télécommande ou l'émetteur de télémesure selon l'invention doit fonctionner est donc égale à la somme du nombre de fréquences de chaque créneau, selon la relation suivante :

$$ M = \sum_{i=1}^{N} M_i $$

La programmation de la fréquence du récepteur selon ce plan de fréquence a pour but de limiter les fréquences possibles aux créneaux disponibles et requis par l'utilisateur.

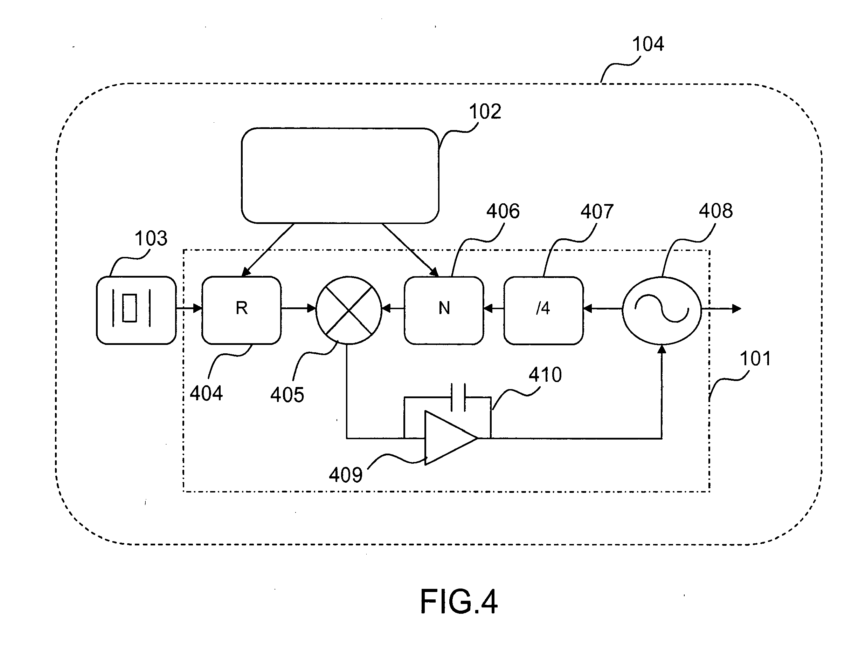

La figure 4 schématise un bloc-diagramme détaillé du dispositif 104 de pilotage en fréquence dont la fonction est de générer la fréquence de fonctionnement du récepteur de télécommande ou de l'émetteur de télémesure selon l'invention. Ce dispositif 104 de pilotage comprend notamment un oscillateur à quartz 103 qui a pour fonction de délivrer une fréquence fixe de référence notée $F_{OCXO}$ à un oscillateur local synthétisé 101 encore appelé synthétiseur de fréquences. Cet oscillateur à quartz 103 est par exemple, un oscillateur à quartz thermostaté ou OCXO. Le synthétiseur de fréquences 101 comprend un dispositif 404 de division de fréquence par un facteur entier R, un mélangeur 405 qui permet de combiner la fréquence de sortie du dispositif diviseur de fréquence 404 avec celle délivrée en sortie d'un second dispositif diviseur de fréquence 406 de rang de division N (où N peut être fractionnaire) et un dispositif d'asservissement de fréquence 409 qui relie la sortie du mélangeur 405 avec l'entrée d'un oscillateur contrôlé en tension 408 plus connu sous l'acronyme anglo-saxon VCO pour « Voltage Controlled Oscillator ». L'oscillateur contrôlé en tension 408 délivre à sa sortie une fréquence $F_{VCO}$ qui est liée à la fréquence de référence de l'oscillateur à quartz 403 par la relation suivante :

$$ F_{VCO} = F_{OCXO} \cdot \frac{N}{R} . (1) $$

Un circuit intégré numérique de conversion 102 réalisant le pilotage de la fréquence du récepteur selon l'invention agit sur les diviseurs 404 et 406 afin de déterminer les valeurs de N et R permettant à partir de la relation (1) de générer la fréquence désirée. Ce circuit intégré numérique peut être un composant logique programmable, une mémoire morte ou tout autre dispositif permettant de délivrer à sa sortie des mots numériques. La fonction de ce circuit intégré numérique est de commander les diviseurs de fréquence 404,406 de l'oscillateur local selon l'invention afin de leur faire appliquer les valeurs des coefficients N et R permettant de générer l'ensemble des fréquences du plan de fréquence tel que décrit à la figure 2. Pour ce faire, ledit circuit intégré numérique 402 implémente une table de conversion qui a pour fonction d'associer à chaque fréquence du plan de fréquence retenu, une adresse binaire. L'ensemble des adresses binaires doit constituer un ensemble contigu afin de limiter le choix des fréquences au strict besoin. A chaque adresse binaire correspond un mot de programmation contenant les valeurs des coefficients N et R qui sont également stockés au sein du circuit 102. Cette solution a pour avantage de restreindre le nombre d'adresses à programmer aux seules fréquences programmables spécifiées et réellement utilisées par l'émetteur/récepteur de liaison satellite TTC. A titre d'exemple, un récepteur capable de fonctionner à 32 fréquences différentes nécessite un champ d'adresses de programmation limité à 5 bits alors que pour un synthétiseur fractionnaire de l'état de l'art fonctionnant en bande Ku, la programmation de 500 000 fréquences nécessite 19 bits..

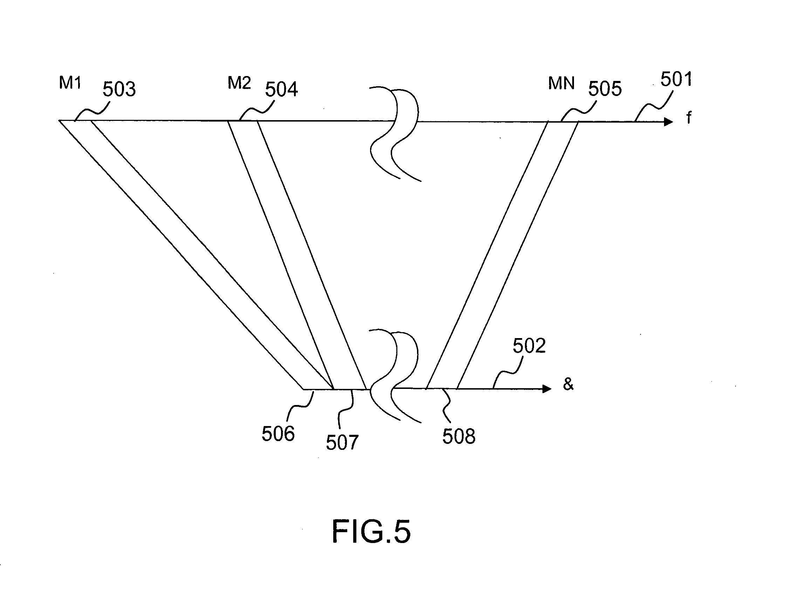

La figure 5 schématise le principe de conversion mis en oeuvre par le circuit de conversion 102 selon l'invention. Un ensemble de créneaux de fréquences 503, 504, 505 est représenté, ces créneaux étant répartis sur l'axe des fréquences 501 de façon discontinue. Chaque créneau contient un nombre différent de fréquences, le premier créneau 503 contient $M_1$ fréquences réparties au sein du créneau de façon continue ou discontinue, le second créneau 504 contient $M_2$ fréquences et le nième créneau 505 contient $M_n$ fréquences. Le circuit de conversion 102 associe à chacun desdits créneaux un groupe d'adresses binaires, l'ensemble des groupes d'adresses étant réparti de façon continue sur l'axe des adresses binaires 502. Le circuit de conversion 102 associe au premier créneau de fréquences 503 un premier groupe d'adresses binaires 506 comprenant une plage d'adresses allant de 0 à $M_1-1$. Le second créneau de fréquences 504 est représenté par un groupe d'adresses 507 dont les valeurs vont de $M_1$ à $M_1+M_2-1$ et ainsi de suite pour chaque groupe d'adresses obtenus par conversion d'un créneau de fréquences.

A titre d'exemple, le créneau de fréquences 503 peut contenir les fréquences suivantes $f_1$=13751,1 MHz, $f_2$=13751,2 MHz, $f_3$=13751,5 MHz et $f_4$=13751,6 MHz qui ne sont pas forcément équiréparties. Le circuit de conversion 102, pour cet exemple, fait correspondre à l'adresse 0 le couple de mots numériques ($N_1,R_1$) permettant à l'oscillateur local synthétisé de générer la fréquence $f_1$. De façon similaire, les adresses 1,2 et 3 correspondent aux couples de mots numériques ($N_2,R_2$), ($N_3,R_3$), ($N_4,R_4$) permettant de générer les fréquences $f_2$, $f_3$ et $f_4$.

La programmation de la table de conversion numérique mise en oeuvre par le circuit de conversion 102 est telle qu'à toute adresse correspond une fréquence utile du récepteur (ou de l'émetteur) de télécommande (ou de télémesure) selon l'invention. Cette table de conversion fait correspondre à une adresse binaire fournie en entrée les mots de programmation nécessaires au pilotage de la fréquence du synthétiseur associée.

Un des avantages de l'invention réside dans le fait de limiter l'ensemble des fréquences possibles auxquelles le récepteur de télécommande ou l'émetteur de télémesure peut fonctionner. L'utilisation d'un dispositif de pilotage de la fréquence permettant de programmer, à l'aide d'une table de conversion, l'ensemble des fréquences de fonctionnement autorisées permet d'alléger considérablement la testabilité des équipements TTC. De plus, l'invention permet également d'éviter l'utilisation d'une fréquence non autorisée, par exemple une fréquence qui serait déjà utilisée par un autre type de transmission. Dans le cas d'applications satellites, le dispositif selon l'invention permet de générer des fréquences dont les valeurs sont limitées au strict emploi du plan de fréquences. L'ensemble des fréquences pouvant être générées peut être vu comme un masque en fréquence adapté au plan de fréquences du système visé. Un tel masque peut être aisément modifié si le plan de fréquences change. Il suffit pour cela de mettre à jour la table de conversion du dispositif. Enfin l'utilisation d'un circuit intégré numérique pour rendre la fréquence programmable permet de réaliser facilement un changement de fréquence au cours de la durée de vie du satellite ce qui n'est pas facilement réalisable avec une architecture de l'état de l'art, notamment dans le cas de satellites qui ne sont pas équipés de liaison série vers les équipements et pour lesquels les changements d'état de la fréquence sont réalisés par incrémentation ou décrémentation des mots de commande.

## Revendications

**1.** Dispositif de pilotage de la fréquence F d'un émetteur et/ou d'un récepteur de liaison satellite TTC à partir d'une commande de fréquence dont la valeur est prise dans un plan de fréquences prédéterminé composé de plusieurs créneaux (503,504,505) de fréquences répartis de façon discontinue dans une bande de fréquence donnée, ledit dispositif étant **caractérisé en ce qu'**il comprend au moins un oscillateur à quartz (103) délivrant une fréquence de référence $F_{OCXO}$, un oscillateur local synthétisé (101) délivrant ladite fréquence F à partir de ladite fréquence de référence Focxo selon la relation suivante

$$F = F_{OCXO}\,\frac{N}{R}$$ où N et R sont des coefficients diviseurs programmables et un circuit intégré numérique (102) qui implémente une table de conversion faisant correspondre à chaque créneau de fréquence (503,504,505) dudit plan de fréquences prédéterminé un ensemble d'adresses binaires réparties de façon contiguë adressant les valeurs desdits coefficients N et R sous forme de mots binaires permettant à l'oscillateur local synthétisé (101) de générer ladite fréquence F dont la valeur est égale à celle de ladite commande en fréquence.

**2.** Dispositif selon la revendication 1 **caractérisé en ce que** ledit circuit intégré numérique (102) est un composant à logique programmable ou une mémoire morte.

**3.** Récepteur de télécommande pour un satellite géostationnaire comprenant au moins un circuit d'entrée analogique d'amplification et de filtrage (106), une première chaine de conversion de fréquence intermédiaire et un circuit de démodulation numérique (113) **caractérisé en ce que** ladite première chaine de conversion de fréquence (114) comprend au moins un mélangeur (107), un circuit d'amplification et de filtrage (108) et un dispositif (104) de pilotage de la fréquence selon l'une des revendications 1 à 2.

**4.** Récepteur de télécommande pour un satellite géostationnaire ou défilant selon la revendication 3 **caractérisé en ce que** ledit récepteur comprend en plus une seconde chaine de conversion de fréquence (109) recevant en entrée le signal de sortie de ladite première chaine de conversion de fréquence (114) et délivrant audit circuit de démodulation (113) un signal à une seconde fréquence intermédiaire.

**5.** Emetteur de télémesure pour un satellite géostationnaire ou défilant comprenant au moins un circuit de modulation (201), un circuit d'amplification et de filtrage (202) et un dispositif (104) de pilotage de la fréquence dudit émetteur selon l'une des revendications 1 à 2.

## Patentansprüche

**1.** Vorrichtung zum Regeln der Frequenz F eines Senders und/oder eines Empfängers einer TTC-Satellitenverbindung auf der Basis eines Frequenzbefehls, dessen Wert von einer vorbestimmten Frequenzebene genommen ist, die sich aus mehreren Frequenzfenstern (503, 504, 505) zusammensetzt, die auf diskontinuierliche Weise über ein gegebenes Frequenzband verteilt sind, wobei die Vorrichtung **dadurch gekennzeichnet ist, dass** sie Folgendes umfasst: wenigstens einen Quarzoszillator (103), der eine Referenzfrequenz $F_{OCXO}$ liefert, einen synthetisierten Lokaloszillator (101), der die Frequenz F auf der Basis der Referenzfrequenz $F_{OCXO}$ gemäß der $F = F_{OCXO} \dfrac{N}{R}$ Gleichung liefert, wobei N und R programmierbare Teilungskoeffizienten sind, und eine digitale integrierte Schaltung (102), die eine Konversionstabelle implementiert, die eine Korrespondenz zwischen jedem Frequenzfenster (503, 504, 505) der vorbestimmten Frequenzebene mit einem Satz von auf zusammenhängende Weise verteilten binären Adressen zum Adressieren der Werte der Koeffizienten N und R in der Form von binären Wörtern herstellt, so dass der synthetisierte Lokaloszillator (101) die Frequenz F erzeugen kann, deren Wert gleich dem des Frequenzbefehls ist.

2. Vorrichtung nach Anspruch 1, **dadurch gekennzeichnet, dass** die digitale integrierte Schaltung (102) eine programmierbare Logikkomponente oder ein Festwertspeicher ist.

3. Fernsteuerempfänger für einen geostationären Satelliten, der wenigstens eine analoge Verstärkungs- und Filterungseingangsschaltung (106), eine erste Frequenzumwandlungskette (114), die an ihrem Ausgang ein Signal mit einer ersten Zwischenfrequenz anlegt, und eine digitale Demodulationsschaltung (113) umfasst, **dadurch gekennzeichnet, dass** die erste Frequenzumwandlungskette (114) wenigstens einen Mixer (107), eine Verstärkungs- und Filterungsschaltung (108) und eine Vorrichtung (104) zum Regeln der Frequenz nach einem der Ansprüche 1 bis 2 umfasst.

4. Fernsteuerungsempfänger für einen geostationären oder sich bewegenden Satelliten nach Anspruch 3, **dadurch gekennzeichnet, dass** der Empfänger ferner eine zweite Frequenzumwandlungskette (109) umfasst, die am Eingang das Ausgangssignal der ersten Frequenzumwandlungskette (114) empfängt und ein Signal mit einer zweiten Zwischenfrequenz an die Demodulationsschaltung (113) anlegt.

5. Telemetriesender für einen geostationären oder beweglichen Satelliten, der wenigstens eine Modulationsschaltung (201), eine Verstärkungs- und Filterungsschaltung (202) und eine Vorrichtung (104) zum Regeln der Frequenz des Senders nach einem der Ansprüche 1 bis 2 umfasst.

**Claims**

1. A device for controlling the frequency F of a transmitter and/or a receiver of a TTC satellite link based on a frequency command, the value of which is taken from a predetermined frequency range composed of a plurality of frequency slots (503, 504, 505) distributed in a discontinuous manner over a given frequency band, said device being **characterised in that** it comprises at least one quartz oscillator (103) delivering a reference frequency $F_{OCXO}$, a synthesised local oscillator (101) delivering said frequency F based on said reference frequency $F_{OCXO}$ according to the following relation $F = F_{OCXO} \dfrac{N}{R}$, where N and R are programmable division coefficients, and a digital integrated circuit (102) that implements a conversion table creating a correspondence between each frequency slot (503, 504, 505) of said predetermined frequency range and a set of binary addresses distributed in a contiguous manner, addressing the values of said coefficients N and R in the form of binary words, allowing said synthesised local oscillator (101) to generate said frequency F, the value of which is equal to that of said frequency command.

2. The device according to claim 1, **characterised in that** said digital integrated circuit (102) is a programmable logic component or a read-only memory.

3. A remote control receiver for a geostationary satellite comprising at least one amplifying and filtering analogue input circuit (106), a first frequency conversion chain (114) delivering at its output a signal at a first intermediate frequency, and a digital demodulation circuit (113), **characterised in that** said first frequency conversion chain (114) comprises at least one mixer (107), an amplifying and filtering circuit (108) and a device (104) for controlling the frequency according to any one of claims 1 to 2.

4. The remote control receiver for a geostationary or moving satellite according to claim 3, **characterised in that** said receiver further comprises a second frequency conversion chain (109) receiving as input the output signal of said first frequency conversion chain (114) and delivering a signal at a second intermediate frequency to said demodulation circuit (113).

5. A telemetry transmitter for a geostationary or moving satellite comprising at least one modulation circuit (201), an amplifying and filtering circuit (202) and a device (104) for controlling the frequency of said transmitter according to any one of claims 1 to 2.

FIG.1

EP 2 409 285 B1

Amplificateur — 202

Modulateur — 201

Oscillateur local — 101

102

103

104

105

FIG.2

8

FIG.3

EP 2 409 285 B1

FIG.4

FIG.5

EP 2 409 285 B1

**EP 2 409 285 B1**

**RÉFÉRENCES CITÉES DANS LA DESCRIPTION**

**Documents brevets cités dans la description**

- WO 9608883 A